# EUROPEAN PATENT APPLICATION

(11) **EP 4 800 154 A2**
(43) Date of publication of application: **02.09.2026**
(21) Application number: 26160352.6
(22) Date of filing: 24.02.2026
(51) Int. Cl.: C23C 16/32, C23C 16/455

(54) **METHODS AND SYSTEMS FOR DEPOSITING TRANSITION METAL-CONTAINING FILMS**

(30) Priority: 27.02.2025 US 202563763978 P
(71) Applicant: ASM IP Holding B.V., 1322 AP Almere (NL)
(72) Inventor: HATANPÄÄ, Timo, 1322 AP Almere (NL); RUIZ Y KÄRKKÄINEN, Paloma, 1322 AP Almere (NL); VIHERVAARA, Anton, 1322 AP Almere (NL); RITALA, Mikko, 1322 AP Almere (NL)
(74) Representative: V.O.

(57) **Abstract**

The present disclosure relates to methods and apparatuses for depositing transition metal - containing material on a substrate by a cyclic deposition process. The method comprises providing a substrate in a reaction chamber, providing a transition metal halide precursor into the reaction chamber in a vapor phase; and providing a second precursor into the reaction chamber in a vapor phase to form a layer comprising transition metal on the substrate. The transition metal halide precursor comprises transition metal tetrahalide.

## Description

The invention claimed herein was made by, or on behalf of, and/or in connection with a joint research agreement between University of Helsinki and ASM Microchemistry Oy. The agreement was in effect on and before the date the claimed invention was made, and the claimed invention was made as a result of activities undertaken within the scope of the agreement.

### FIELD OF INVENTION

The present invention relates to methods and systems for the manufacture of semiconductor devices. More particularly, the disclosure relates to methods and assemblies for depositing transition metal -containing material on a substrate by a cyclical deposition process, and layers comprising transition metal -containing material.

### BACKGROUND

Transition metal carbides (TMCs) are widely used in catalytic and wear resistance applications. They exhibit excellent chemical and thermal stabilities, exceptional hardnesses, and low resistivities. Additionally, they typically have good electromigration resistances. These properties make them relatively good conductors as their metal wire dimensions shrink to the sub-10 nm range. Development of TMC ALD processes opens the possibility to use carbides in semiconductor applications. The ALD of metal carbides is, however, still in its infancy, and current challenges include a lack of thermal ALD processes, high process temperatures, and low growth rates. Transition metal carbides, such as molybdenum carbides, MoCx, have the potential to improve the performance, efficiency, and reliability of semiconductor devices. Recently, they have emerged as potential candidates for diffusion barriers, interconnects, and gate electrodes.

Any discussion, including discussion of problems and solutions, set forth in this section has been included in this disclosure solely for the purpose of providing a context for the present disclosure. Such discussion should not be taken as an admission that any or all of the information was known at the time the invention was made or otherwise constitutes prior art.

### BRIEF SUMMARY

This summary is provided to introduce a selection of concepts in a simplified form. These concepts are described in further detail in the detailed description of example embodiments of the disclosure below. This summary is not intended to identify key features or essential features of the claimed subject matter, nor is it intended to be used to limit the scope of the claimed subject matter.

Various embodiments of the present disclosure relate to method for forming a layer comprising transition metal on a substrate by a cyclic deposition process is disclosed. The method comprises providing a substrate into a reaction chamber and executing at least one deposition cycle. Each deposition cycle comprises providing a transition metal halide precursor in vapor phase into a reaction chamber and providing a second precursor in vapor phase into a reaction chamber to form a layer comprising transition metal on a substrate. In the method, the transition metal halide precursor comprises transition metal tetrahalide.

In some embodiments, the transition metal halide precursor comprises a transition metal selected from the group IV to VIII transition metals. In some embodiments, the transition metal halide precursor comprises a transition metal selected from the group consisting of molybdenum, chromium, tungsten, nickel, cobalt, niobium, copper, titanium, palladium, platinum, zirconium, hafnium, vanadium, tantalum, manganese, rhodium, iron, iridium and rhenium. In some embodiments, the transition metal halide precursor comprises a transition metal selected from the group VI transition metals. In some embodiments, the halogen in the transition metal halide precursor is selected from the group consisting of chlorine, iodine, fluorine and bromine. In some embodiments, the transition metal halide precursor comprises molybdenum tetrachloride.

In another aspect, a transition metal carbide layer produced by a cyclic deposition process is disclosed. The method comprises providing a substrate into a reaction chamber and executing at least one deposition cycle. Each deposition cycle comprises providing a transition metal halide precursor in vapor phase into a reaction chamber and providing a second precursor in vapor phase into a reaction chamber to form a layer comprising transition metal on a substrate. In the method, the transition metal halide precursor comprises transition metal tetrahalide.

In some embodiments, the second precursor acts as a reducing agent and/or a carbon donor. In some embodiments, the second precursor comprises a cyclic diene compound comprising a substituent comprising metalloid. In some embodiments, the metalloid comprises a trialkyl metalloid. In some embodiments, the second precursor may also include where the metalloid of the second precursor is a germanium or silicon. In some embodiments, the second precursor may also include where the cyclic diene is a five or six membered cyclic diene. In some embodiments, the second precursor comprises a cyclohexadiene compound selected from the compound of formula (I), 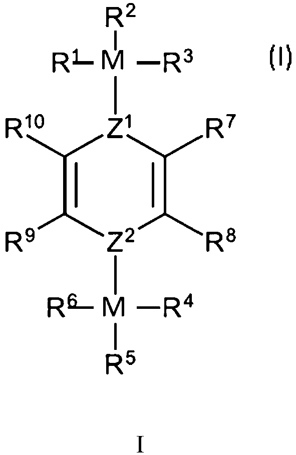 where M is either Ge or Si, each of Z¹ and Z² is independently selected from CR¹¹ and N, each of R¹ to R¹¹, is independently H, C1 to C7 linear or branched alkyl, C6 to C10 aryl or C6 to C14 heteroaryl. In some embodiments, the second precursor may also include where R¹¹ is H. In some embodiments, the second precursor may also include where each of R⁷ to R¹⁰ is independently selected from a group consisting of H, C1 to C4 linear and branched alkyls and phenyl. In some embodiments, the second precursor may also include where all of R⁷ to R¹⁰ are H. In some embodiments, the second precursor may also include where each of R¹ to R⁶ is independently selected from a group consisting of H, methyl, ethyl, n-propyl and isopropyl. In some embodiments, the second precursor may also include where all of R¹ to R⁶ are methyl. In some embodiments, the second precursor comprises a cyclohexadiene compound selected from the compound of formula (II), 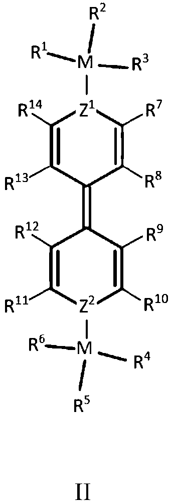 where M is either Ge or Si, each of Z¹ and Z² is independently selected from CR¹⁵ and N, each of R¹ to R¹⁵, is independently H, C1 to C7 linear or branched alkyl, C6 to C10 aryl or C6 to C14 heteroaryl. In some embodiments, the second precursor may also include where R¹⁵ is H. In some embodiments, the second precursor may also include where each of R⁷ to R¹⁴ is independently selected from a group consisting of H, C1 to C4 linear and branched alkyls and phenyl. In some embodiments, the second precursor may also include where all of R⁷ to R¹⁴ are H. In some embodiments, the second precursor may also include where each of R¹ to R⁶ is independently selected from a group consisting of H, methyl, ethyl, n-propyl and isopropyl. In some embodiments, the second precursor may also include where all of R¹ to R⁶ are methyl. In some embodiments, the second precursor is selected from the group consisting of 1,4-bis(trimethylgermyl)-1,4-dihydropyrazine, 1,4-bis(trimethylsilyl)-1,4-dihydropyrazine, 1,1'-bis(trimethylsilyl)-1,1'-dihydro-4,4'-bipyridine and 1,1'-bis(trimethylgermyl)-1,1'-dihydro-4,4'-bipyridine.

In some embodiments, the layer comprising transition metal comprises elemental transition metal. In some embodiments, the the second precursor comprises a metal selected from the list consisting of zinc, sodium, magnesium and aluminum. Other technical features may be readily apparent to one skilled in the art from the following figures, descriptions, and claims.

In yet another aspect, a method for making transition metal tetrahalide precursor is disclosed. The method comprises mixing transition metal pentahalide, diethyl ether and tin in a vessel to form a mixture; washing the mixture with diethyl ether to remove tin chloride from the mixture to form an intermediate product; and heating the intermediate product to obtain transition metal tetrahalide.

In some embodiments, the transition metal includes molybdenum. In some embodiments, the halide in the transition metal tetrahalide and in the transition metal pentahalide includes chloride. In some embodiments, the intermediate product includes MoCl₄(Et₂O)₂. In some embodiments, the heating is performed for more than 90 minutes at about 90 °C under vacuum. Other technical features may be readily apparent to one skilled in the art from the following figures, descriptions, and claims.

In another aspect, a vapor delivery vessel comprising transition metal tetrahalide precursor for depositing a layer comprising transition metal is disclosed. The vapor delivery vessel comprises an outer wall that encloses a cavity for storing the film forming composition and a gas outlet for allowing a vapor of the film forming composition to exit the cavity. The vessel is configured to supply a vapor of the precursor to a semiconductor processing apparatus chamber.

In some embodiments, the vapor delivery vessel further comprises a gas inlet and a conduit that extends into the cavity to a fixed point. The conduit may extend into the cavity and into the film forming composition for passing a carrier gas through the film forming composition. Alternatively, the conduit may extend into the cavity to a point that is above the film forming composition for passing a carrier gas over the surface of the film forming composition.

In some embodiments, the vapor delivery vessel further comprises a probe member. The probe member may comprise one or more temperature sensors and/or one or more level sensors and one or more pressure sensors.

In some embodiments, the outer wall and the cavity of the vapor delivery vessel are formed from stainless steel. In some embodiments, the vessel is suitable to be attached to a vapor deposition reactor.

In one aspect, a deposition assembly for depositing a layer comprising transition metal on a substrate is disclosed. The deposition assembly comprises; one or more reaction chambers constructed and arranged to hold the substrate, a precursor injector system constructed and arranged to provide a transition metal halide precursor and a second precursor into the reaction chamber in vapor phase. The deposition assembly comprises a first precursor vessel constructed and arranged to contain and evaporate a transition metal halide precursor comprising transition metal tetrahalide, a second precursor vessel constructed and arranged to contain and evaporate a second precursor, and wherein the assembly is constructed and arranged to provide the transition metal halide precursor and the second precursor via the precursor injector system to the reaction chamber to deposit a layer comprising transition metal on the substrate.

In some embodiments, the assembly further comprises a temperature controller for controlling the temperature of the reaction chamber.

These and other embodiments will become readily apparent to those skilled in the art from the following detailed description of certain embodiments having reference to the attached figures. The invention is not limited to any particular embodiments disclosed.

### BRIEF DESCRIPTION OF THE DRAWINGS

A more complete understanding of the embodiments of the present disclosure may be derived by referring to the detailed description and claims when considered in connection with the following illustrative figures. To easily identify the discussion of any particular element or act, the most significant digit or digits in a reference number refer to the figure number in which that element is first introduced.
FIG. 1 illustrates a schematic representation method 100 in accordance with one embodiment.
FIG. 2 illustrates an aspect of the subject matter in accordance with one embodiment.

It will be appreciated that elements in the figures are illustrated for simplicity and clarity and have not necessarily been drawn to scale. For example, the dimensions of some of the elements in the figures may be exaggerated relative to other elements to help improve understanding of illustrated embodiments of the present disclosure.

### DETAILED DESCRIPTION

Although certain embodiments and examples are disclosed below, it will be understood by those in the art that the invention extends beyond the specifically disclosed embodiments and/or uses of the invention and obvious modifications and equivalents thereof. Thus, it is intended that the scope of the invention disclosed should not be limited by the particular disclosed embodiments described below.

The description of exemplary embodiments of methods, structures, devices and systems provided below is merely exemplary and is intended for purposes of illustration only; the following description is not intended to limit the scope of the disclosure or the claims. Moreover, recitation of multiple embodiments having stated features is not intended to exclude other embodiments having additional features or other embodiments incorporating different combinations of the stated features. For example, various embodiments are set forth as exemplary embodiments and may be recited in the dependent claims. Unless otherwise noted, the exemplary embodiments or components thereof may be combined or may be applied separate from each other.

In this disclosure, "gas" can include material that is a gas at normal temperature and pressure (NTP), a vaporized solid and/or a vaporized liquid, and can be constituted by a single gas or a mixture of gases, depending on the context. A gas other than the process gas, i.e., a gas introduced without passing through a gas distribution assembly, other gas distribution device, or the like, can be used for, e.g., sealing the reaction space, and can include a seal gas, such as a rare gas. In some cases, the term "precursor" can refer to a compound that participates in the chemical reaction that produces another compound, and particularly to a compound that constitutes a film matrix or a main skeleton of a film; the term "reactant" can be used interchangeably with the term precursor. Exemplary gasses can include precursors and reactants.

As used herein, the term "comprising" indicates that certain features are included, but that it does not exclude the presence of other features, as long as they do not render the claim or embodiment unworkable. In some embodiments, the term "comprising" includes "consisting". As used herein, the term "consisting" indicates that no further features are present in the apparatus/method/product apart from the ones following said wording. When the term "consisting" is used referring to a chemical compound or substance, it indicates that the chemical compound only contains the components which are listed.

As used herein, the term "substrate" can refer to any underlying material or materials that can be used to form, or upon which, a device, a circuit, or a film can be formed. A substrate can include a bulk material, such as silicon (e.g., single-crystal silicon), other Group IV materials, such as germanium, or other semiconductor materials, such as Group II-VI or Group III-V semiconductor materials, and can include one or more layers overlying or underlying the bulk material. Further, the substrate can include various features, such as recesses, protrusions, and the like formed within or on at least a portion of a layer of the substrate. By way of examples, a substrate can include bulk semiconductor material and an insulating or dielectric material layer overlying at least a portion of the bulk semiconductor material. Additionally or alternatively, an exemplary substrate can comprise bulk semiconductor material and a conductive layer overlying at least a portion of the bulk semiconductor material.

As used herein, "step coverage" refers to the growth rate of a layer on a distal end relative to the opening of a recess, divided by the growth rate of that layer on a proximal end relative to the opening of the recess, expressed as a percentage. Step coverage provides a measure of the conformity of a layer.

As used herein, a "vapor delivery vessel" refers to a vessel that is suitable for or configured for vapor delivery of a substance that is contained within the vessel. The vapor delivery vessel comprises an outer wall that encloses a cavity for storing and/or holding the substance and a fluid outlet for allowing a vapor of the substance to exit the cavity. The substance contained within the cavity may be a composition that is suitable for vapor deposition or etch methods. For example, the substance contained within the cavity may comprise one or more precursors, one or more reactants, one or more etchants, or one or more surface treatment agents, as applicable. The substance contained within the cavity may be a homogeneous or heterogenous mixture. The substance contained within the cavity may be in a solid form, a liquid form, a gaseous form, or a combination thereof. The vapor delivery vessel may be a vapor draw vessel, a carrier gas vessel, a double walled vessel, a sublimation vessel, and/or other configuration.

As used herein, the term "film" and/or "layer" can refer to any continuous or noncontinuous structure and material, such as material deposited by the methods disclosed herein. For example, a film and/or layer can include two-dimensional materials, three-dimensional materials, nanoparticles, partial or full molecular layers or partial or full atomic layers or clusters of atoms and/or molecules. A film or layer may partially or wholly consist of a plurality of dispersed atoms on a surface of a substrate and/or embedded in a substrate / and/or embedded in a device manufactured on that substrate. A film or layer may comprise material or a layer with pinholes and/or isolated islands. A film or layer may be at least partially continuous. A film or layer may be patterned, e.g. subdivided, and may be comprised in a plurality of semiconductor devices.

As used herein, a "structure" can be or include a substrate as described herein. Structures can include one or more layers overlying the substrate, such as one or more layers formed according to a method as described herein. Device portions and interconnects can be or include structures.

The term "deposition process" as used herein can refer to the introduction of precursors (and/or reactants) into a reaction chamber to deposit a layer over a substrate. "Cyclical deposition processes" are examples of "deposition processes".

In the current disclosure, the deposition process may comprise a cyclic deposition process, such as an atomic layer deposition (ALD) process or a cyclic chemical vapor deposition (CVD) process. The term "cyclic deposition process" can refer to the sequential introduction of precursor(s) and/or reactant(s) into a reaction chamber to deposit material, such as a metal or semimetal-containing material, on a substrate. Cyclic deposition includes processing techniques such as atomic layer deposition (ALD), cyclic chemical vapor deposition (cyclic CVD), and hybrid cyclic deposition processes that include an ALD component and a cyclic CVD component. The process may comprise a purge step between providing precursors or between providing a precursor and a reactant in the reaction chamber.

The process may comprise one or more cyclic phases. For example, pulsing of a transition metal halide precursor precursor and second precursor may be repeated. In some embodiments, the process comprises or one or more acyclic phases. In some embodiments, the deposition process comprises the continuous flow of at least one precursor. In some embodiments, a reactant may be continuously provided in the reaction chamber. In such an embodiment, the process comprises a continuous flow of a precursor or a reactant. In some embodiments, one or more of the precursors and/or reactants are provided in the reaction chamber continuously. In some embodiments, auxiliary reactant may be provided in the reaction chamber continuously.

The term "atomic layer deposition" (ALD) can refer to a vapor deposition process in which deposition cycles, such as a plurality of consecutive deposition cycles, are conducted in a reaction chamber. Generally, for ALD processes, during each cycle, a precursor is introduced to a reaction chamber and is chemisorbed to a deposition surface (e.g., a substrate surface that may include a previously deposited material from a previous ALD cycle or other material), forming about a monolayer or sub-monolayer of material that does not readily react with additional precursor (i.e., a self-limiting reaction). Thereafter, in some cases, another precursor or a reactant may subsequently be introduced into the process chamber for use in converting the chemisorbed precursor to the desired material on the deposition surface. The second precursor or a reactant can be capable of further reaction with the precursor. Purging steps may be utilized during one or more cycles, e.g., during each step of each cycle, to remove any excess precursor from the process chamber and/or remove any excess reactant and/or reaction byproducts from the reaction chamber. Thus, in some embodiments, the cyclic deposition process comprises purging the reaction chamber after providing a transition metal halide precursor into the reaction chamber. In some embodiments, the cyclic deposition process comprises purging the reaction chamber after providing a second precursor into the reaction chamber. In some embodiments, the cyclic deposition process comprises purging the reaction chamber after providing any precursor or reactant into the reaction chamber.

CVD type processes typically involve gas phase reactions between two or more precursors and/or reactants. The precursor(s) and reactant(s) can be provided simultaneously to the reaction space or substrate, or in partially or completely separated pulses. The substrate and/or reaction space can be heated to promote the reaction between the gaseous precursor and/or reactants. In some embodiments the precursor(s) and reactant(s) are provided until a layer having a desired thickness is deposited. In some embodiments, cyclic CVD processes can be used with multiple cycles to deposit a thin film having a desired thickness. In cyclic CVD processes, the precursors and/or reactants may be provided to the reaction chamber in pulses that do not overlap, or that partially or completely overlap.

As used herein, the term "purge" may refer to a procedure in which a purge gas is provided to a reaction chamber in between a precursor pulse and a plasma pulse or between a precursor pulse and a reactant pulse. It shall be understood that during a purge, the substrate is not exposed to plasma-generated species. For example, when a direct plasma is used, the plasma can be turned off during a purge. For example, a purge, e.g. using a purge gas such as nitrogen or a noble gas, may be provided between a precursor pulse and a reactant pulse, thus avoiding or at least minimizing gas phase interactions between the precursor and the reactant. It shall be understood that a purge can be effected either in time or in space, or both. For example in the case of temporal purges, a purge step can be used e.g. in the temporal sequence of providing a first precursor to a reaction chamber, providing a purge gas to the reaction chamber, and providing a second precursor to the reaction chamber, wherein the substrate on which a layer is deposited does not move. For example in the case of spatial purges, a purge step can take the following form: moving a substrate from a first location to which a first precursor is continually supplied, through a purge gas curtain, to a second location to which a second precursor is continually supplied.

As used herein, a "precursor" includes a gas or a material that can become gaseous and that can be represented by a chemical formula that includes an element which may be incorporated during a deposition process as described herein.

Further, in this disclosure, any two numbers of a variable can constitute a workable range of the variable, and any ranges indicated may include or exclude the endpoints. Additionally, any values of variables indicated (regardless of whether they are indicated with "about" or not) may refer to precise values or approximate values and include equivalents, and may refer to average, median, representative, majority, or the like. Further, in this disclosure, the terms "including," "constituted by" and "having" refer independently to "typically or broadly comprising," "comprising," "consisting essentially of," or "consisting of" in some embodiments.

"At least one", "one or more", and "and/or" are open-ended expressions that are both conjunctive and disjunctive in operation. For example, each of the expressions "at least one of A, B, and C", "at least one of A, B, or C", "one or more of A, B, and C", "one or more of A, B, or C" and "A, B, and/or C" means A alone, B alone, C alone, A and B together, A and C together, B and C together, or A, B and C together. When each one of A, B, and C in the above expressions refers to an element, such as X, Y, and Z, or class of elements, such as X₁-Xₙ, Y₁-Yₘ, and Z₁-Zₒ, the phrase is intended to refer to a single element selected from X, Y, and Z, a combination of elements selected from the same class (e.g., X₁ and X₂) as well as a combination of elements selected from two or more classes (e.g., Yi and Zₒ).

In this disclosure, any defined meanings do not necessarily exclude ordinary and customary meanings, in some embodiments.

In the deposition methods according to the current disclosure, layer comprising transition metal is deposited. In some embodiments, the material deposited according to the current disclosure comprises transition metal carbide, in other words carbidic transition metal. By carbidic transition metal is herein meant carbon that is bonded to the transition metal. This does not for example include carbon impurities found in the deposited material. In some embodiments, the material deposited according to the current disclosure consists essentially of, or consists of transition metal carbide. In some embodiments, at least 60 % of transition metal carbide is deposited as carbidic transition metal. In some embodiments, at least 80 % or at least 90 % of transition metal carbide is deposited as carbidic transition metal. In one embodiment, the transition metal carbide has the structure according to the general formula MC, wherein M is the transition metal. In one embodiment, the transition metal carbide has the structure according to the general formula M₂C, wherein M is the transition metal.

In some embodiments, the material deposited according to the current disclosure comprises elemental transition metal. In some embodiments, the material deposited according to the current disclosure consists essentially of, or consists of elemental transition metal. In some embodiments, at least 60% of transition metal is deposited as elemental transition metal. In some embodiments, at least 80% or at least 90% of transition metal is deposited as elemental transition metal.

Without limiting the current disclosure to any specific theory, in some embodiments it may be possible to produce layers with low resistivity, especially when transition metal carbide is deposited. The resistivity of a metal layer according to the current disclosure may be less than 400 µΩ cm or less than 320 µΩ cm or less than 250 µΩ cm or less than 170 µΩ cm. For example, the resistivity of a transition metal carbide layer according to the current disclosure may be from about 5 µΩ cm to about 520 µΩ cm, from about 5 µΩ cm to about 350 µΩ cm, or from about 5 µΩ cm to about 300 µΩ cm, or from about 5 µΩ cm to about 250 µΩ cm.

In another aspect, a method for making transition metal tetrahalide precursor is disclosed. The method comprises mixing transition metal pentahalide, diethyl ether and tin in a vessel to form a mixture; washing the mixture with diethyl ether to remove tin chloride from the mixture to form an intermediate product; and heating the intermediate product to obtain transition metal tetrahalide.

In some embodiments, the transition metal includes molybdenum. In some embodiments, the halide in the transition metal tetrahalide and in the transition metal pentahalide includes chloride. In some embodiments, the intermediate product includes MoCl₄(Et₂O)₂. In some embodiments, the heating is performed for more than 90 minutes at about 90 °C under vacuum. Other technical features may be readily apparent to one skilled in the art from the following figures, descriptions, and claims.

In another aspect, a vapor delivery vessel comprising transition metal tetrahalide precursor for depositing a layer comprising transition metal is disclosed. The vapor delivery vessel comprises an outer wall that encloses a cavity for storing the film forming composition and a gas outlet for allowing a vapor of the film forming composition to exit the cavity. The vessel is configured to supply a vapor of the precursor to a semiconductor processing apparatus chamber.

In some embodiments, the vapor delivery vessel further comprises a gas inlet and a conduit that extends into the cavity to a fixed point. The conduit may extend into the cavity and into the film forming composition for passing a carrier gas through the film forming composition. Alternatively, the conduit may extend into the cavity to a point that is above the film forming composition for passing a carrier gas over the surface of the film forming composition.

In some embodiments, the vapor delivery vessel further comprises a probe member. The probe member may comprise one or more temperature sensors and/or one or more level sensors and one or more pressure sensors.

In some embodiments, the outer wall and the cavity of the vapor delivery vessel are formed from stainless steel. In some embodiments, the vessel is suitable to be attached to a vapor deposition reactor.

The disclosure is further explained by the following exemplary embodiments depicted in the drawings. The illustrations presented herein are not meant to be actual views of any particular material, structure, device or an apparatus, but are merely schematic representations to describe embodiments of the current disclosure. It will be appreciated that elements in the figures are illustrated for simplicity and clarity and have not necessarily been drawn to scale. For example, the dimensions of some of the elements in the figures may be exaggerated relative to other elements to help improve the understanding of illustrated embodiments of the present disclosure. The structures and devices depicted in the drawings may contain additional elements and details, which may be omitted for clarity.

The particular implementations shown and described are illustrative of the invention and are not intended to otherwise limit the scope of the aspects and implementations in any way. Indeed, for the sake of brevity, conventional manufacturing, connection, preparation, and other functional aspects of the system may not be described in detail. Furthermore, the connecting lines shown in the various figures are intended to represent exemplary functional relationships and/or physical couplings between the various elements. Many alternative or additional functional relationship or physical connections may be present in the practical system, and/or may be absent in some embodiments.

It is to be understood that the configurations and/or approaches described herein are exemplary in nature, and that these specific embodiments or examples are not to be considered in a limiting sense, because numerous variations are possible. The specific routines or methods described herein may represent one or more of any number of processing strategies. Thus, the various acts illustrated may be performed in the sequence illustrated, in other sequences, or omitted in some cases.

The subject matter of the present disclosure includes all novel and nonobvious combinations and subcombinations of the various processes, systems, and configurations, and other features, functions, acts, and/or properties disclosed herein, as well as any and all equivalents thereof.

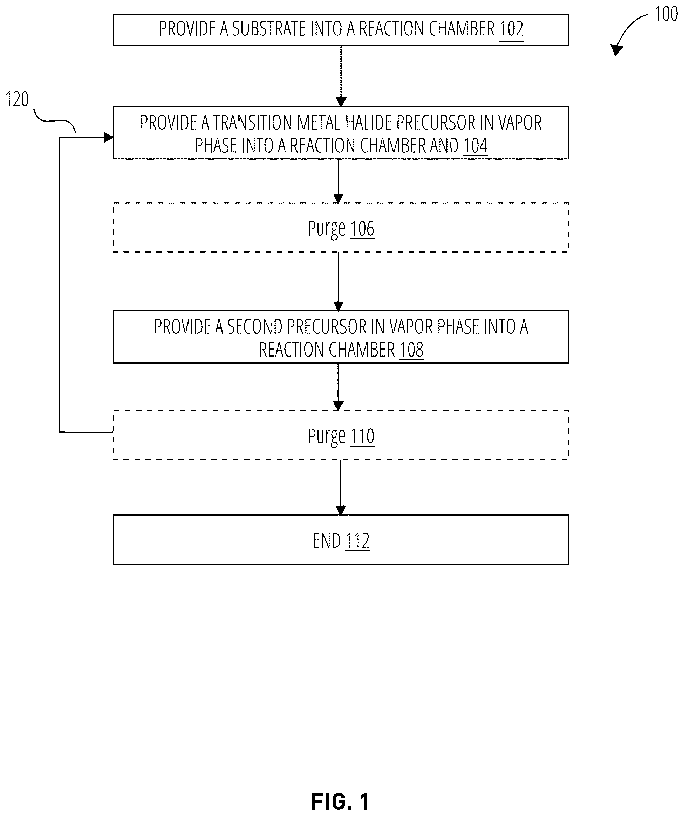

FIG. 1 illustrates a block diagram of an exemplary embodiment of a method 100 of depositing layer comprising transition metal on a substrate. In block 102, method 100 provides a substrate into a reaction chamber. A substrate according to the current disclosure may comprise, for example, an oxide, such as silicon oxide (for example thermal silicon oxide or native silicon oxide). A substrate may comprise a nitride, such as silicon nitride or titanium nitride, a metal, such as copper, cobalt or tungsten, chalcogenide material, such as molybdenum sulfide. The transition metal -containing material according to the current disclosure may be deposited on said surfaces.

The reaction chamber can form part of an atomic layer deposition (ALD) assembly. The reaction chamber can form part of a chemical vapor deposition (CVD) assembly. The assembly may be a single wafer reactor. Alternatively, the reactor may be a batch reactor. The assembly may comprise one or more multi-station deposition chambers. Various phases of method 100 can be performed within a single reaction chamber or they can be performed in multiple reaction chambers, such as reaction chambers of a cluster tool. In some embodiments, the method 100 is performed in a single reaction chamber of a cluster tool, but other, preceding or subsequent, manufacturing steps of the structure or device are performed in additional reaction chambers of the same cluster tool. Optionally, an assembly including the reaction chamber can be provided with a heater to activate the reactions by elevating the temperature of one or more of the substrate and/or the reactants and/or precursors. The transition metal -containing material according to the current disclosure may be deposited in a cross-flow reaction chamber. The transition metal -containing material according to the current disclosure may be deposited in a showerhead reaction chamber. In some embodiments, the reaction chamber may be a space-divided reactor. In some embodiments, the reaction chamber may be single wafer ALD reactor. In some embodiments, the reaction chamber may be a high-volume manufacturing single wafer ALD reactor. In some embodiments, the reaction chamber may be a batch reactor for manufacturing multiple substrates simultaneously. A reaction chamber according to the current disclosure may further be a deposition station in a multi-station chamber.

In block 104, method 100 provides a transition metal halide precursor in vapor phase into a reaction chamber. Without limiting the current disclosure to any specific theory, transition metal halide precursor may chemisorb on the substrate during providing transition metal halide precursor into the reaction chamber. The duration of providing transition metal halide precursor into the reaction chamber (transition metal halide precursor pulse time) may be, for example, 0.1 seconds, 0.5 seconds, 1 second, 1.5 seconds, 2 seconds, 3 seconds, 4 seconds or 5 seconds.

In the method according to the current disclosure, the transition metal halide precursor may be in vapor phase when it is in a reaction chamber. The transition metal halide precursor or may be partially gaseous or liquid, or even solid at some points in time prior to being provided in the reaction chamber. In other words, a transition metal halide precursor may be solid, liquid or gaseous, for example, in a precursor vessel or other receptacle before delivery in a reaction chamber. Various means of bringing the precursor in to gas phase can be applied when delivery into the reaction chamber is performed. Such means may include, for example, heaters, vaporizers, gas flow or applying lowered pressure, or any combination thereof. Thus, the method according to the current disclosure may comprise heating the transition metal halide precursor prior to providing it to the reaction chamber.

In some embodiments, the deposition of a transition metal -containing material according to the current disclosure is performed at a temperature below about 450 °C, or below about 380 °C, or below about 360 °C. In some embodiments, the deposition is performed at a temperature from about 240°C to about 310 °C, for example from about 200°C to about 300 °C, for example from about 350 °C to about 420 °C such as at a temperature of about 250 °C, about 275 °C or at about 300 °C or at about 420 °C. In some embodiments, the deposition is performed at a temperature from about 250°C to about 450 °C, for example from about 300°C to about 400 °C, such as at a temperature of about 325 °C, about 350 °C, about 375 °C, 400 °C, about 425 °C or at about 450 °C.

In some embodiments, a transition metal halide precursor is heated to at least 30 °C, to at least 50 °C, or to at least 70 °C, or to at least 90 °C or to at least 110 °C or to at least 140 °C or to at least 200 °C before providing it to the reaction chamber. In some embodiments, a transition metal halide precursor is heated to at least 100 °C, or to at least 130 °C. The heating may take place in a precursor vessel. In some embodiments, the transition metal halide precursor is heated to at most 180 °C, or to at most 170 °C, or to at most 160 °C. or to at most 250 °C, before providing it to the reaction chamber. The injector system of a vapor deposition assembly may be heated to improve the vapor-phase delivery of the transition metal precursor to the reaction chamber.

In some embodiments, the transition metal halide precursor comprises a transition metal for depositing layer comprising transition metal on the substrate. In some embodiments, the transition metal halide precursor comprises a group 4 to 8 transition metal for depositing group 4 to 8 layer comprising transition metal on the substrate. In some embodiments, the transition metal in the transition metal halide precursor is selected from the group consisting of molybdenum (Mo), chromium (Cr), tungsten (W), nickel (Ni), cobalt (Co), niobium (Nb), copper (Cu), titanium (Ti), palladium (Pd), platinum (Pt), zirconium (Zr), hafnium (Hf), vanadium (V), tantalum (Ta), manganese (Mn), rhodium (Rh), iron (Fe), iridium (Ir) and rhenium (Re). In some embodiments, the transition metal in the transition metal halide precursor is selected from a group consisting of chromium (Cr), molybdenum (Mo) and tungsten (W). In some embodiments, the transition metal in the transition metal halide precursor is selected from a group consisting of scandium (Sc), yttrium (Y), titanium (Ti), zirconium (Zr), hafnium (Hf), vanadium (V), niobium (Nb), tantalum (Ta), chromium (Cr), molybdenum (Mo), tungsten (W), manganese (Mn), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), zinc (Zn), cadmium (Cd). In some embodiments, the transition metal in the transition metal precursor is selected from a group consisting of molybdenum (Mo), chromium (Cr), tungsten (W), nickel (Ni), cobalt (Co), niobium (Nb), rhenium (Re), copper (Cu), gold (Au), titanium (Ti), palladium (Pd), platinum (Pt), rhodium (Rh) and ruthenium (Ru). In some embodiments, the metal precursor comprises a lanthanide group metal for depositing lanthanide series metal on the substrate. In some embodiments, the transition metal in the transition metal precursor is selected from a group consisting of chromium (Cr), molybdenum (Mo), niobium (Nb) and tungsten (W). In some embodiments, the transition metal in the transition metal precursor may be molybdenum (Mo). In some embodiments, the transition metal precursor consists only of the transition metal and halogen.

In some embodiments, the halogen in the transition metal halide precursor is selected from the group consisting of chlorine, iodine, fluorine and bromine. In some embodiments, the transition metal halide precursor comprises molybdenum tetrachloride.

In some embodiments, transition metal precursor is provided in a mixture of two or more compounds. In a mixture, the other compounds in addition to the transition metal precursor may be inert compounds or elements. In some embodiments, transition metal precursor is provided in a composition. Compositions suitable for use as composition can include a transition metal compound and an effective amount of one or more stabilizing agents. Composition may be a solution or a gas in standard conditions.

In block 106, the method 100 provides an optional purge step. During purge step, precursor and/or reactant can be temporally separated from each other by inert gases, such as argon (Ar), nitrogen (N2) or helium (He) and/or a vacuum pressure. The separation of transition metal halide precursor and second precursor may alternatively be spatial. For example in the case of spatial purges, a purge step can take the following form: moving a substrate from a first location to which a transition metal halide precursor precursor is continually supplied, through a purge gas curtain, to a second location to which a second precursor is continually supplied. Purging times may be, for example, from about 0.01 seconds to about 20 seconds, from about 0.05 s to about 20 s, or from about 1 s to about 20 s, or from about 0.5 s to about 10 s, or between about 1 s and about 7 seconds, such as 1 s, 2 s or 3 s. However, other purge times can be utilized if necessary, such as where highly conformal step coverage over extremely high aspect ratio structures or other structures with complex surface morphology is needed, or in specific reactor types, such as a batch reactor, may be used.

Purging the reaction chamber 106 may prevent or mitigate gas-phase reactions between a transition metal halide precursor and a second precursor, and enable possible self-saturating surface reactions. Surplus chemicals and reaction byproducts, if any, may be removed from the substrate surface, such as by purging the reaction chamber or by moving the substrate, before the substrate is contacted with the next reactive chemical. In some embodiments, however, the substrate may be moved to separately contact a transition metal halide precursor and a second precursor. Because in some embodiments, the reactions may self-saturate, strict temperature control of the substrates and precise dosage control of the precursors may not be required. However, the substrate temperature is preferably such that an incident gas species does not condense into monolayers or multimonolayers nor thermally decompose on the surface.

In block 108, method 100 provides a second precursor in vapor phase into a reaction chamber. In some embodiments, the second precursor comprises a cyclic diene compound comprising a substituent comprising metalloid. In some embodiments, the metalloid comprises a trialkyl metalloid. In some embodiments, the second precursor may also include where the metalloid of the second precursor is a germanium or silicon. In some embodiments, the second precursor may also include where the cyclic diene is a five or six membered cyclic diene.

In some embodiments, the second precursor comprises a reducing agent and/or carbon donor for reducing the transition metal halide precursor and optionally depositing transition metal carbide on the substrate. In some embodiments, the second precursor comprises a reducing agent, a carbon donor and a nitrogen donor for simultaneously reducing the transition metal halide precursor and deposition transition metal carbonitride on the substrate. In some embodiments, the second precursor comprises a carbon precursor for depositing transition metal carbide on the substrate. The duration of providing second precursor into the reaction chamber (second precursor pulse time) may be, for example, 0.5 seconds, 1 second, 1.5 seconds, 2 seconds, 3 seconds, 4 seconds or 5 seconds.

In some embodiments, the second precursor is a reducing agent. A reducing agent may reduce the transition metal of the transition metal halide precursor into elemental metal. In some embodiments, the second precursor is a carbon donor. A carbon donor may give a carbon atom to the transition metal of the transition metal halide precursor to form transition metal carbide. In some embodiments, the second precursor acts both as a reducing agent and a carbon donor. In some embodiments, the second precursor is a nitrogen donor. A nitrogen donor may give a nitrogen atom to the transition metal of the transition metal halide precursor to form transition metal nitride. In some embodiments, the second precursor acts both as a reducing agent and a nitrogen donor. In some embodiments, the second precursor acts both as a reducing agent, a carbon donor and a nitrogen donor.

For simplicity of nomenclature, the term cyclic diene encompasses ring structures comprising only carbon, as well as ring structures comprising one or two nitrogen atoms. In some embodiments, the cyclic diene is a five or six membered cyclic diene. Thus, in addition to the metalloid groups, the cyclic diene ring may have additional substituents. In some embodiments, one or more of the ring carbons have an alkyl substituent. The alkyl substituents may be linear or branched. In some embodiments, one ring carbon has a C1 to C7 alkyl substituent. In some embodiments, two ring carbons have a C1 to C7 alkyl substituent. In some embodiments, three ring carbons have a C1 to C7 alkyl substituent. In some embodiments, four ring carbons have a C1 to C7 alkyl substituent. If a germanium atom or silicon atom is attached to the cyclic diene through a carbon atom, the same carbon atom may have an additional alkyl substituent. In some embodiments, all the additional substituents to ring carbons are C1 to C4 alkyls. In some embodiments, all of the additional substituents are methyl or ethyl groups. In some embodiments, all of the additional substituents are methyl groups. In some embodiments, all of the additional substituents are ethyl groups. In some embodiments, the cyclohexadiene compound has one additional substituent, and the additional substituent is a methyl group. In some embodiments, the cyclic diene compound has one additional substituent, and the additional substituent is an ethyl group. In some embodiments, the methyl group is attached to a carbon adjacent to a germanium group bonded carbon atom. In some embodiments, however, none of the ring carbons have additional substituents.

Increasing molecular weight of the cyclic diene compound generally adversely impacts its volatility. Thus, the more substituents the cyclic diene ring comprises, the smaller they need to be to retain sufficient volatility.

In some embodiments, the two metalloid groups of the cyclohexadiene compound are trialkylmetalloid groups. In some embodiments, the two trialkylmetalloid groups comprise C1 to C7 alkyl groups. The alkyl groups may be linear or branched. In some embodiments, the two metalloid groups of the cyclic diene compound are trimethylmetalloid groups. In some embodiments, the two metalloid groups of the cyclohexadiene compound are triethylmetalloid groups.

In some embodiments, the cyclohexadiene compound according to the current disclosure has a structure according to formula (VI), wherein M is a metalloid. In some embodiments, the cyclohexadiene compound according to the current disclosure has a structure according to formula (VII), wherein M is a metalloid. In some embodiments, the cyclohexadiene compound according to the current disclosure has a structure according to formula (VIII), wherein M is a metalloid. In some embodiments, the cyclohexadiene compound according to the current disclosure has a structure according to formula (IX), wherein M is a metalloid. In some embodiments, the cyclohexadiene compound according to the current disclosure has a structure according to formula (X), wherein M is a metalloid. In some embodiments, the cyclohexadiene compound according to the current disclosure has a structure according to formula (XI), wherein M is a metalloid. In some embodiments, the 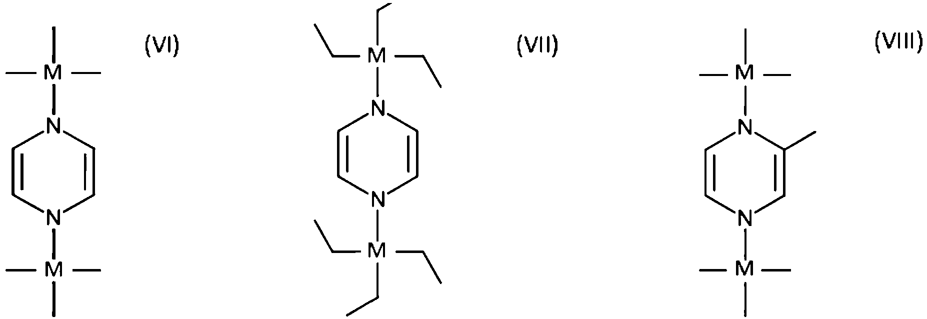 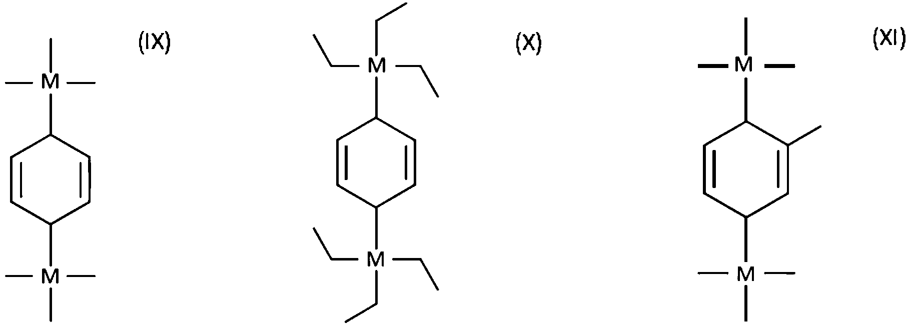 metalloid is selected from the group consisting of germanium and silicon.

In some embodiments, the cyclohexadiene compound according to the current disclosure has a structure according to formula (XII),

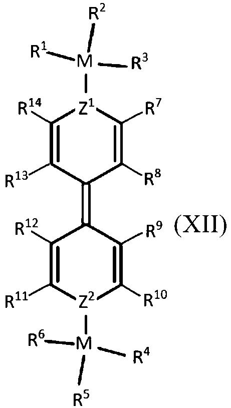

wherein M is a metalloid, each of Z¹ and Z² is independently selected from CR¹⁴ and N, each of R¹ to R¹⁴, is independently H, C1 to C7 linear or branched alkyl, C6 to C10 aryl or C6 to C14 heteroaryl. In one embodiment, R¹¹ is H. In one embodiment, each of R⁷ to R¹⁴ is independently selected from a group consisting of H, C1 to C4 linear and branched alkyls and phenyl. In one embodiment all of R⁷ to R14 are H. In one embodiment, each of R1 to R6 is independently selected from a group consisting of H, methyl, ethyl, n-propyl and isopropyl. In one embodiment, wherein all of R1 to R6 are methyl.

In one embodiment, the second precursor is 1,4-bis(trimethylgermyl)-1,4-dihydropyrazine. In one embodiment, the second precursor is 1,4-bis(trimethylsilyl)-1,4-dihydropyrazine. In one embodiment, the second precursor is 1,1'-bis(trimethylsilyl)-1,1'-dihydro-4,4'-bipyridine. In one embodiment, the second precursor is 1,1'-bis(trimethylgermyl)-1,1'-dihydro-4,4'-bipyridine.

In some embodiments, the layer comprising transition metal comprises elemental transition metal. In these embodiments, the second precursor acts as a reducing agent to reduce the transition metal halide precursor into the metal. In some embodiments, the second precursor comprises a metal selected from the list consisting of zinc and aluminum. In some embodiments, the second precursor comprises zinc. In some embodiments, the second precursor may be in elemental metal form. In some embodiments, the second precursor may be part of a compound, such as a metal halide.

Similarly to the transition metal halide precursor, a second precursor may be heated before providing it to the reaction chamber. The temperature to which the second precursor is heated depends on the properties of the second precursor. As is understood by those skilled in the art, the vaporization temperatures of the transition metal precursor and the second precursors may need to be compatible.

In some embodiments, a second precursor is heated to at least 20 °C, to at least 25 °C to at least 50 °C, or to at least 70 °C, or to at least 90 °C or to at least 100 °C or to at least 110 °C before providing it to the reaction chamber. The heating may take place in a precursor vessel. In some embodiments, the second precursor is heated to at most 120 °C, or to at most 100 °C, or to at most 80 °C, or to at most 60 °C before providing it to the reaction chamber. In some embodiments, a second precursor is heated to at least 350 °C, or to at least 370 °C or to at least 390 °C before providing it to the reaction chamber. The heating may take place in a precursor vessel. In some embodiments, the second precursor is heated to at most 450 °C, or to at most 430 °C, or to at most 410 °C before providing it to the reaction chamber. The injector system of a vapor deposition assembly may be heated to improve the vapor-phase delivery of the second precursor to the reaction chamber.

In block 110, the method 100 provides an optional purge step. This purge step can be similar to purge step 106 as explained above.

Phases of providing a transition metal halide precursor 104 and providing a second precursor 108 may be performed in any order. The phases of providing a transition metal halide precursor 104 and providing a second precursor 108 may constitute a deposition cycle, resulting in the deposition of transition metal -containing material. In some embodiments, the two phases of transition metal -containing material deposition, namely providing the transition metal halide precursor and the second precursor in the reaction chamber (104 and 106), may be repeated (loop 120). Such embodiments contain several deposition cycles. The thickness of the deposited transition metal carbide-containing material may be regulated by adjusting the number of deposition cycles. The deposition cycle (loop 120) may be repeated until a desired transition metal -containing material thickness is achieved. For example, about 50, 100, 200, 300, 400, 500, 700, 800, 1,000, 1,200, 1,500, 2,000, 2,400 or 3,000 deposition cycles may be performed. The cyclical deposition may result in the formation of a transition metal -containing layer. The layer may be substantially continuous or continuous. Once the desired thickness is formed on the surface of the substrate, the method 100 ends 112.

When performing the method 100, transition metal -containing material is deposited onto the substrate. The deposition process may be a cyclical deposition process, and may include cyclical CVD, ALD, or a hybrid cyclical CVD/ALD process. For example, in some embodiments, the growth rate of a particular ALD process may be low compared with a CVD process. One approach to increase the growth rate may be that of operating at a higher deposition temperature than that typically employed in an ALD process, resulting in some portion of a chemical vapor deposition process, but still taking advantage of the sequential introduction of a transition metal halide precursor and a second precursor. Such a process may be referred to as cyclical CVD. In some embodiments, a cyclical CVD process may comprise the introduction of two or more precursors into the reaction chamber, wherein there may be a time period of overlap between the two or more precursors in the reaction chamber resulting in both an ALD component of the deposition and a CVD component of the deposition. This is referred to as a hybrid process. In accordance with further examples, a cyclical deposition process may comprise the continuous flow of one reactant or precursor and the periodic pulsing of the other chemical component into the reaction chamber. The temperature and/or pressure within a reaction chamber during step 104 can be the same or similar to any of the pressures and temperatures noted above in connection with step 102.

In some embodiments, the transition metal halide precursor is brought into contact with a substrate surface 104, excess transition metal halide precursor is partially or substantially completely removed by an inert gas or vacuum 106, and second precursor is brought into contact with the substrate surface comprising transition metal halide precursor. Transition metal halide precursor may be brought in to contact with the substrate surface in one or more pulses 104. In other words, pulsing of the transition metal precursor 104 may be repeated. The transition metal halide precursor on the substrate surface may react with the second precursor to form transition metal-containing material on the substrate surface. Also pulsing of the second precursor 108 may be repeated. In some embodiments, second precursor may be provided in the reaction chamber first 104. Thereafter, the reaction chamber may be purged 106 and transition metal halide precursor provided in the reaction chamber in one or more pulses 108.

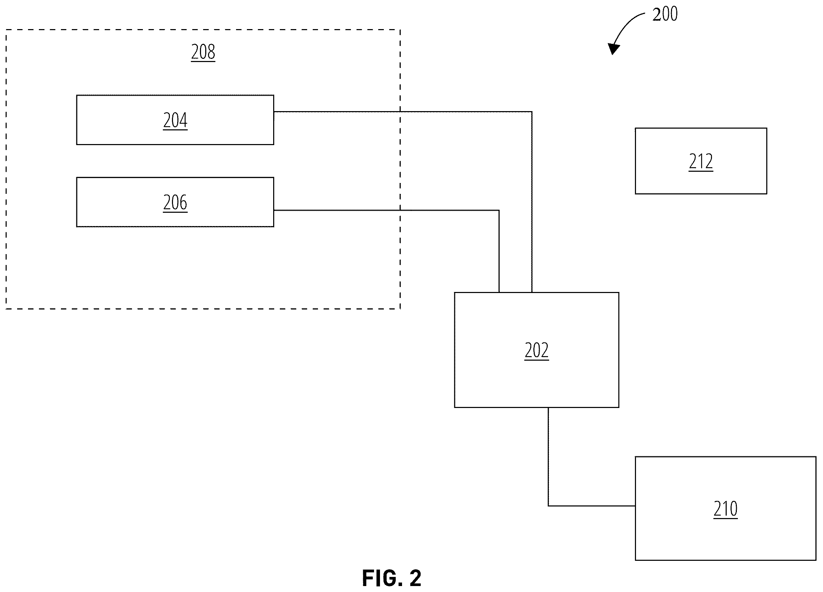

FIG. 2 illustrates a deposition assembly 200 according to the current disclosure in a schematic manner. Deposition assembly 200 can be used to perform a method as described herein and/or to form a structure or a device, or a portion thereof as described herein.

In the illustrated example, deposition assembly 200 includes one or more reaction chambers 202, a precursor injector system 208, a transition metal halide precursor vessel 204, a second precursor vessel 206, an exhaust source 210, and a controller 212. The deposition assembly 200 may comprise one or more additional gas sources (not shown), such as an inert gas source, a carrier gas source and/or a purge gas source.

Reaction chamber 202 can include any suitable reaction chamber, such as an ALD or CVD reaction chamber as described herein.

The transition metal halide precursor vessel 204 can include a vessel and one or more transition metal halide precursors as described herein - alone or mixed with one or more carrier (e.g., inert) gases. A second precursor vessel 206 can include a vessel and a second precursor as described herein - alone or mixed with one or more carrier gases. Although illustrated with two source vessels 204, 206, deposition assembly 200 can include any suitable number of source vessels. Source vessels 204, 206 can be coupled to reaction chamber 202 via lines 214,216, which can each include flow controllers, valves, heaters, and the like. In some embodiments, the transition metal halide precursor in the transition metal halide precursor vessel 204 and the second precursor in the second precursor vessel 206 may be heated. In some embodiments, a vessel is heated so that a precursor or a reactant reaches a temperature between, for example, about 20 °C and about 450 °C, depending on the properties of the chemical in question.

Exhaust source 210 can include one or more vacuum pumps.

Controller 212 includes electronic circuitry and software to selectively operate valves, manifolds, heaters, pumps and other components included in the deposition assembly 200. Such circuitry and components operate to introduce precursors, reactants and purge gases from the respective sources. Controller 212 can control timing of gas pulse sequences, temperature of the substrate and/or reaction chamber 202, pressure within the reaction chamber 202, and various other operations to provide proper operation of the deposition assembly 200. Controller 212 can include control software to electrically or pneumatically control valves to control flow of precursors, reactants and purge gases into and out of the reaction chamber 202. Controller 212 can include modules such as a software or hardware component, which performs certain tasks. A module may be configured to reside on the addressable storage medium of the control system and be configured to execute one or more processes.

Other configurations of deposition assembly 200 are possible, including different numbers and kinds of precursor and reactant sources. Further, it will be appreciated that there are many arrangements of valves, conduits, precursor sources, and auxiliary reactant sources that may be used to accomplish the goal of selectively and in coordinated manner feeding gases into reaction chamber 202. Further, as a schematic representation of a deposition assembly, many components have been omitted for simplicity of illustration, and such components may include, for example, various valves, manifolds, purifiers, heaters, containers, vents, and/or bypasses.

During operation of deposition assembly 200, substrates, such as semiconductor wafers (not illustrated), are transferred from, e.g., a substrate handling system to reaction chamber 202. Once substrate(s) are transferred to reaction chamber 202, one or more gases from gas sources, such as precursors, reactants, carrier gases, and/or purge gases, are introduced into reaction chamber 202.

In some embodiments, the transition metal halide precursor is supplied in pulses, the second precursor is supplied in pulses and the reaction chamber is purged between consecutive pulses of a transition metal halide precursor and a second precursor.

The example embodiments of the disclosure described above do not limit the scope of the invention, since these embodiments are merely examples of the embodiments of the invention, which is defined by the appended claims and their legal equivalents. Any equivalent embodiments are intended to be within the scope of this invention. Various modifications of the disclosure, in addition to those shown and described herein, such as alternative useful combinations of the elements described, may become apparent to those skilled in the art from the description. Such modifications and embodiments are also intended to fall within the scope of the appended claims.

## Claims

1. A method for forming a layer comprising transition metal on a substrate, the method comprises
providing a substrate into a reaction chamber;
executing at least one deposition cycle, wherein the deposition cycle comprises;
providing a transition metal halide precursor in vapor phase into a reaction chamber and
providing a second precursor in vapor phase into a reaction chamber;
to form a layer comprising transition metal on a substrate, wherein the transition metal halide precursor comprises transition metal tetrahalide.

2. The method of claim 1, wherein the transition metal halide precursor comprises a transition metal selected from the group IV to VIII transition metals.

3. The method of claim 1, wherein the transition metal halide precursor comprises a transition metal selected from the group consisting of molybdenum, chromium, tungsten, nickel, cobalt, niobium, copper, titanium, palladium, platinum, zirconium, hafnium, vanadium, tantalum, manganese, rhodium, iron, iridium and rhenium.

4. The method of any one of claims 1 to 3, wherein the transition metal halide precursor comprises a transition metal selected from the group VI transition metals.

5. The method of any one of claims 1 to 4, wherein the halogen in the transition metal halide precursor is selected from the group consisting of chlorine, iodine, fluorine and bromine.

6. The method of any one of claims 1 to 5, wherein the transition metal halide precursor comprises molybdenum tetrachloride.

7. The method of claim 1, wherein the layer comprising transition metal comprises transition metal carbide.

8. The method of claim 7, wherein the second precursor acts as a reducing agent and/or a carbon donor.

9. The method of claim 7 or 8, wherein the second precursor comprises a cyclic diene compound comprising a substituent comprising metalloid.

10. The wherein the second precursor of any one of claims 7 to 9, wherein the substituent comprising metalloid comprises a trialkyl metalloid.

11. The wherein the second precursor of any one of claims 7 to 10, wherein the metalloid of the second precursor is a germanium or silicon.

12. The wherein the second precursor of any one of claims 7 to 11, wherein the cyclic diene is a five or six membered cyclic diene.

13. The wherein the second precursor of any one of claims 7 to 12, wherein the second precursor comprises a cyclohexadiene compound selected from the compound of formula (I), 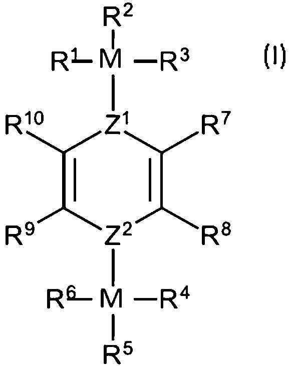 wherein M is either Ge or Si, each of Z¹ and Z² is independently selected from CR¹¹ and N, each of R¹ to R¹¹, is independently H, C1 to C7 linear or branched alkyl, C6 to C10 aryl or C6 to C14 heteroaryl.

14. The wherein the second precursor of claim 13, wherein R¹¹ is H.

15. The wherein the second precursor of claim 13 or 14, wherein each of R⁷ to R¹⁰ is independently selected from a group consisting of H, C1 to C4 linear and branched alkyls and phenyl.

16. The wherein the second precursor of any one of claims 13 to 15, wherein all of R⁷ to R¹⁰ are H.

17. The wherein the second precursor of any one of claims 13 to 16, wherein each of R¹ to R⁶ is independently selected from a group consisting of H, methyl, ethyl, n-propyl and isopropyl.

18. The wherein the second precursor of any one of claims 13 to 17, wherein all of R¹ to R⁶ are methyl.

19. A deposition assembly for depositing a layer comprising transition metal on a substrate, the deposition assembly comprising;
one or more reaction chambers constructed and arranged to hold the substrate;
a precursor injector system constructed and arranged to provide a transition metal halide precursor and a second precursor into the reaction chamber in vapor phase;
wherein the deposition assembly comprises a first precursor vessel constructed and arranged to contain and evaporate a transition metal halide precursor comprising transition metal tetrahalide;
a second precursor vessel constructed and arranged to contain and evaporate a second precursor; and
wherein the assembly is constructed and arranged to provide the transition metal halide precursor and the second precursor via the precursor injector system to the reaction chamber to deposit a layer comprising transition metal on the substrate.

20. The deposition assembly of claim 19, wherein the assembly further comprises a temperature controller for controlling the temperature of the reaction chamber.
